# EUROPÄISCHE PATENTSCHRIFT

(11) **EP 0 398 045 B1**
(45) Veröffentlichungstag und Bekanntmachung des Hinweises auf die Patenterteilung: **09.03.1994**
(21) Anmeldenummer: 90107776.8
(22) Anmeldetag: 24.04.1990
(51) Int. Cl.: B23K 3/02, B23K 3/04, H05K 13/04

(54) **Lötvorrichtung mit mindestens einer durch elektrische Widerstandswärme erhitzbaren Bügelelektrode**
Soldering device with at least one U-shaped electrode heated by electric resistance
Dispositif à souder avec au moins une électrode en U échauffée par résistance électrique

(30) Priorität: 19.05.1989 DE 3916353
(43) Veröffentlichungstag der Anmeldung: 22.11.1990
(73) Patentinhaber: Siemens Nixdorf Informationssysteme Aktiengesellschaft, 33102 Paderborn (DE)
(72) Erfinder: Schuster, Rudolf, Dipl.-Ing., D-8011 Heimstetten (DE)
(74) Vertreter: Fuchs, Franz-Josef, Dr.-Ing.

(56) Entgegenhaltungen:
- EP-A- 0 306 748
- DE-A- 3 722 726
- DE-A- 3 722 765
- FR-A- 2 496 519

## Beschreibung

Die Erfindung betrifft eine Lötvorrichtung mit mindestens einer durch elektrische Widerstandswärme erhitzbaren Bügelelektrode, insbesondere für das Auflöten hochpoliger elektronischer Bauelemente auf Leiterplatten.

Eine derartige Lötvorrichtung ist beispielsweise aus der DE-A-31 49 236 bekannt. Der Elektrodenhalter dieser bekannten Lötvorrichtung umfaßt elektrisch voneinander isolierte, kleine Säulen aus elektrisch leitfähigem Material, zwischen deren Enden in auswechselbarer Weise mindestens zwei Bügelelektroden befestigt sind. Die U-förmigen Bügelelektroden, die durch elektrische Widerstandswärme erhitzt werden können, sind aus einer ebenen Platte aus einem Widerstandsmaterial wie Tantal oder Molybdän hergestellt und in der Weise angebracht, daß sie mit der Unterseite ihres Lötsteges in Kontakt mit den zu verlötenden Elementen kommen. Bei einer Anzahl von zwei oder vier Bügelelektroden werden für die Elektrodenhalter insgesamt vier kleine Säulen benötigt, die auf einer jeweiligen Diagonalen der Lötvorrichtung angeordnet sind und durch mehrerer kreuzförmige Verstrebungen mechanisch miteinander verbunden sind. Zur Stromversorgung von vier Bügelelektroden werden zwei auf einer Diagonale liegende kleine Säulen mit dem einen Pol einer Stromquelle verbunden, während die beiden anderen kleinen Säulen mit dem anderen Pol der Stromquelle verbunden werden.

Aus der DE-A-28 18 958 ist eine andere Lötvorrichtung bekannt, bei welcher der Elektrodenhalter zwei elektrisch voneinander isolierte kleine Säulen aus leitfähigem Material umfaßt, zwischen deren Enden eine einzige Bügelelektrode in auswechselbarer Weise befestigt ist. Diese Bügelelektrode besitzt jedoch insgesamt vier Lötstege, welche die Form eines einstückigen, rechteckförmigen Rahmens aufweisen, wobei zwei einander gegenüberliegende Lötstege über nach oben ragende Fortsätze an den zugeordneten kleinen Säulen auswechselbar befestigt sind.

Aus der EP-A-0 011 046 ist eine weitere Lötvorrichtung bekannt, bei welcher eine einzige an einem Elektrodenhalter befestigte Bügelelektrode insgesamt vier paarweise einander gegenüberliegende Lötstege besitzt, welche die Form eines einstückigen, rechteckförmigen Rahmens aufweisen.

Aus der DE-A-3 722 726 ist eine weitere Lötvorrichtung bekannt, bei welcher die Bügelelektrode fur Begrenzung des Weges gegenüber den zu verbindenden Teilen mit einem Anschlag versehen ist.

Die vorstehend geschilderten bekannten Lötvorrichtungen werden insbesondere für das Auflöten hochpoliger elektronischer Bauelemente wie Mikropacks, Flatpacks und dergleichen auf Leiterplatten eingesetzt, wobei die Widerstandserwärmung der Bügelelektrode durch Stromimpulse vorgenommen wird. Dabei muß sowohl vor dem Lötvorgang als auch während der gesamten Dauer des Lötvorganges ein sicherer Kontakt zwischen den Arbeitsflächen der Bügelelektroden, den Anschlußbeinchen der Bauelemente und den Leiterbahnen bzw. Anschlußpads der Leiterplatten gewährleistet sein. Diese Forderung kann jedoch selbst dann nicht immer gewährleistet werden, wenn die Lötstege absolut parallel zur Lötstelle ausgerichtet sind.

Der Erfindung liegt die Aufgabe zugrunde, eine Lötvorrichtung der eingangs genannten Art so zu verbessern, daß während der gesamten Dauer des Lötvorganges ein sicherer Kontakt zwischen den Lötstegen, den Anschlußbeinchen der Bauelemente und den Leiterbahnen bzw. Anschlußpads der Leiterplatten gewährleistet ist.

Diese Aufgabe wird erfindungsgemäß dadurch gelöst, daß die Enden des der Lötstelle zugewandten Lötsteges der Bügelelektrode als U-förmige Ausdehnungs-Kompensationsstege zurückgeführt sind und daß an den inneren Enden der Ausdehnungs-Kompensationsstege vertikal zum Lötsteg ausgerichtete und im Abstand zueinander angeordnete Haltestege angebracht sind.

Der Erfindung liegt die Erkenntnis zugrunde, daß die Widerstandserwärmung der Bügelelektrode eine thermische Längenausdehnung des Lötsteges bewirkt und daß diese thermische Längenausdehnung durch die feste Einspannung der Haltestege zu einer Verwölbung des Lötsteges führt und damit auch einen unzureichenden Kontakt zwischen Lötsteg und Lötstelle zur Folge hat. Dieser nachteilige Effekt kann jedoch durch die erfindungsgemäßen Ausdehnungs-Kompensationsstege zumindest weitgehend ausgeschlossen werden, da diese Ausdehnungs-Kompensationsstege die thermische Längenausdehnung des Lötsteges in bezug auf die Haltestege wieder ausgleichen.

Gemäß einer besonders bevorzugten Ausgestaltung der erfindungsgemäßen Lötvorrichtung entspricht der Abstand zwischen den beiden Haltestegen etwa der halben Länge des Lötsteges. Bei einer derartigen Bemessung bewirkt die über die Haltestege eingeleitete Kraft Richtmomente, die beim Aufsetzen des Lötsteges auf konkave oder konvexe Verwölbungen der Leiterplatte stets gleich groß sind und somit im elastischen Bereich des Lötsteges eine optimale Anpassung an Leiterplattenunebenheiten ermöglichen.

Obwohl die Summe der Längen der beiden Ausdehnungs-Kompensationsstege geringer ist als die Länge des Lötsteges kann eine vollständige Kompensation der thermischen Längenänderung des Lötsteges erreicht werden. Hierzu kann der Querschnitt der Ausdehnungs-Kompensationsstege derart bemessen sein, daß dort durch die Widerstandserwärmung eine höhere Temperatur entsteht als im Lötsteg. Die Ausdehnungs-Kompensationsstege können aber auch aus einem Material bestehen, dessen thermischer Ausdehnungskoeffizient größer ist als der thermische Ausdehnungskoeffizient des Materials des Lötsteges. Selbstverständlich können auch die beiden vorstehenden Möglichkeiten miteinander kombiniert werden, um eine vollständigen Ausgleich der thermischen Längenausdehnung des Lötsteges zu erzielen.

Gemäß einer weiteren Ausführungsform der Erfindung kann jeweils im Bereich eines Haltesteges zwischen dem Ausdehnungs-Kompensationssteg und dem Lötsteg eine elektrisch isolierende Abstützung angeorndet sein. Diese Abstützungen gewährleisten auch bei geringen Querschnitten der Ausdehnungs-Kompensationsstege eine sichere Krafteinleitung in den Lötsteg.

Gemäß einer weiteren besonders bevorzugten Ausgestaltung der erfindungsgemäßen Lötvorrichtung ist vorgesehen, daß auf die Unterseite des Lötsteges der Bügelelektrode eine elektrisch isolierende Keramikbeschichtung aufgebracht ist. Durch eine derartige Keramikbeschichtung kann ein Abfließen des der Bügelelektrode zugeführten Stroms über niederohmige Leiterbahnen mit Sicherheit ausgeschlossen werden. Andererseits ergibt sich durch die verhinderte Verwölbung des Lötsteges eine ausgezeichnete Haftung der Keramikbeschichtung auf der Unterseite des Lötsteges.

Ein Ausführungsbeispiel der Erfindung ist in der Zeichnung dargestellt und wird im folgenden näher beschrieben.

Es zeigen
- Fig. 1: eine erfindungsgemäße ausgebildete Bügelelektrode in der Draufsicht,
- Fig. 2: einen Querschnitt eines mit einer Keramikbeschichtung versehenen Lötsteges und
- Fig. 3: die Abstimmung des Abstandes zwischen den Haltestegen auf die Länge des Lötsteges bei einem Lötbügel gemäß Fig. 1.

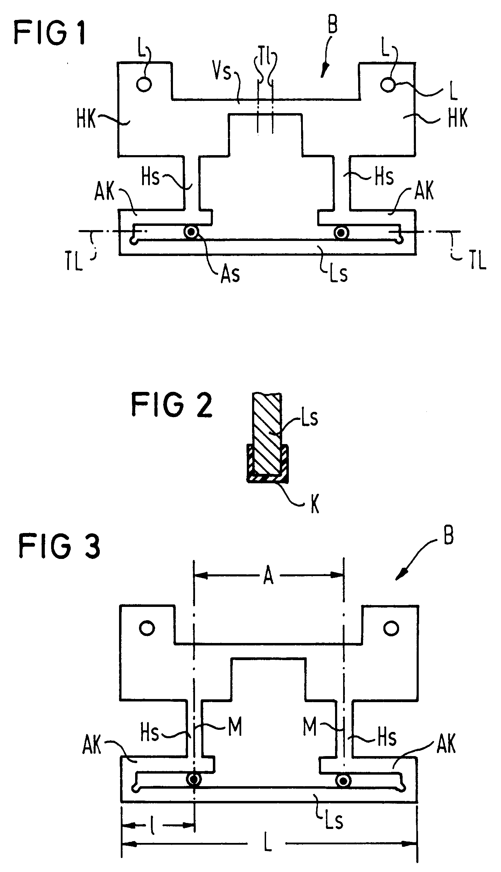

Fig. 1 zeigt eine aus einer ebenen Platte herausgebildete Bügelelektrode B, deren Lötsteg Ls auf eine Lötstelle aufgesetzt wird bzw. nach Beendigung des Lötvorganges von der Lötstelle abgehoben wird. Um Verwölbungen des Lötsteges Ls zu vermeiden und stets einen sicheren Kontakt zwischen der Unterseite des Lötsteges Ls und der jeweiligen Lötstelle zu gewährleisten sind an den äußeren Enden des Lötsteges Ls U-förmig zurückführende Ausdehnungs-Kompensationsstege AK angeformt, deren innere Enden einstückig mit vertikal nach oben führenden Haltestegen Hs verbunden sind. Die beiden parallel im Abstand zueinander angeordneten Haltestege Hs erweitern sich im oberen Bereich zu Halte- und Kontaktiergliedern HK, die einerseits Löcher L zur mechanischen Befestigung der Bügelelektrode B in einem nicht dargestellten Elektrodenhalter besitzen und andererseits das Anlöten von ebenfalls nicht dargestellten Stromzuführungskabeln ermöglichen. Ein zwischen den Halte- und Kontaktiergliedern HK sich erstreckender Verbindungssteg Vs wird nach der Montage der Bügelelektrode B durchtrennt, so wie es durch die strichpunktierten Trennlinien Tl angedeutet ist.

Unterhalb der Haltestege Hs befindet sich zwischen dem Ausdehnungs-Kompensationssteg HK und dem Lötsteg Ls jeweils eine elektrisch isolierende Abstützung As. Diese im dargestellten Ausführungsbeispiel als Keramikröhrchen ausgebildeten Abstützungen As gewährleisten eine sichere Krafteinleitung von den Haltestegen Hs in den Lötsteg Ls.

Damit bei speziellen Anwendungsfällen, wie beim Auflöten mehrpoliger Bauelemente auf mehrlagige Leiterplatten, der der Bügelelektrode B in Form von Stromimpulsen zugeführte Strom beim Aufsetzen auf die Lötstelle nicht über niederohmige Leiterbahnen abfließen kann, ist die Unterseite des Lötsteges Ls gemäß Fig. 2 mit einer Keramikbeschichtung K versehen, die beispielsweise eine Stärke von 75 Mikrometern aufweist. Um bei gekrümmten Anschlußbeinchen aufzulötender elektronischer Bauelemente einen elektrischen Kontakt mit diesen Anschlußbeinchen zu verhindern, ist die Keramikbeschichtung K auch seitlich etwas hochgezogen. Als Materialien für die Keramikbeschichtung K sind beispielsweise Titanoxid, Aluminiumoxid, Aluminiumnitrid, Berylliumoxid, Titanaluminiumnitrid oder Chromoxid geeignet.

Gemäß Fig. 3 ist der Abstand zwischen den Mittellinien M der Haltestege Hs mit A bezeichnet, während die Länge des Lötsteges Ls mit L bezeichnet ist. Um eine optimale elastische Anpassung des Lötsteges Ls an Leiterplattenunebenheiten zu gewährleisten, entspricht der Abstand A der halben Länge L. In diesem Fall werden über die Haltestege Hs sowohl bei konkaven als auch konvexen Verwölbungen einer Leiterplatte gleich große Richtmomente auf den Lötsteg Ls ausgeübt.

Im dargestellten Ausführungsbeispiel entspricht die Länge 1 der Ausdehnungs-Kompensationsstege AK einem Viertel der Länge L des Lötsteges Ls. Um eine thermische Längenausdehnung des Lötsteges Ls über die Ausdehnungs-Kompensationssteg AK vollständig zu kompensieren, muß dann der Querschnitt dieser Ausdehnungs-Kompensationsstege AK so bemessen sein, daß sich dort eine Temperatur einstellt, die doppelt so hoch ist, wie die Arbeitstemperatur im Lötsteg Ls. Es ist aber auch möglich, die Ausdehnungskompensationsstege AK aus einem Material zu fertigen, dessen thermischer Ausdehnungskoeffizient doppelt so groß ist, wie der thermische Ausdehnungskoeffizient des Material des Lötsteges Ls. Die Lötstege Ls und die Ausdehnungs-Kompensationsstege AK sind dabei im vertikalen Schenkelbereich der gebildeten U-Form einstückig miteinander verschweißt, so wie es in Fig. 1 durch die strichpunktierten Material-Trennlinien TL angedeutet ist.

Die beiden vorstehend aufgeführten Möglichkeiten zur vollständigen Kompensation der thermischen Längenausdehnung des Lötsteges Ls können auch miteinander kombiniert werden. So besteht im dargestellten Ausführungsbeispiel der Lötsteg Ls beispielsweise aus einer Nickel-Eisen-Legierung mit folgender chemischer Zusammensetzung (Gewichtsprozent)

| | |
|---|---|
| Ni | 29 |
| Mn | 0,2 |
| Si | 0,2 |
| Fe | Rest |
| Co | 18 |
| C | 0,03 |

Ausdehnungsbeiwert (10⁻⁶/K) von 20 bis 200° C: 5,5
Die Ausdehnungs-Kompensationsstege AK bestehen aus einer Nickel-Eisen-Legierung mit folgender chemischer Zusammensetzung (Gewichtsprozent)

| | |
|---|---|
| Ni | 41 |
| Mn | 0,5 |
| Si | 0,2 |
| Fe | Rest |
| C | 0,01 |

Ausdehnungsbeiwert (10⁻⁶/K) von 20 bis 200° C: 4,3.

In diesem Fall muß der Querschnitt der Ausdehungs-Kompensationsstege AK so bemessen sein, daß sich dort zur vollständigen Kompensation der thermischen Längenausdehnung des Lötsteges Ls eine entsprechend höhere Temperatur einstellt, als im Lötsteg Ls.

## Patentansprüche

1. Lötvorrichtung mit mindestens einer durch elektrische Widerstandswärme erhitzbaren Bügelelektrode, insbesondere für das Auflöten hochpoliger elektronischer Bauelemente auf Leiterplatten,
**dadurch gekennzeichnet,**
daß die Enden des der Lötstelle zugewandten Lötsteges (Ls) der Bügelelektrode (B) als U-förmige Ausdehnungs-Kompensationsstege (AK) zurückgeführt sind und daß an den inneren Enden der Ausdehnungs-Kompensationsstege (AK) vertikal zum Lötsteg (Ls) ausgerichtete und im Abstand (A) zueinander angeordnete Haltestege (Hs) angebracht sind.

2. Lötvorrichtung nach Anspruch 1,
**dadurch gekennzeichnet,**
daß der Abstand (A) zwischen den beiden Haltestegen (Hs) etwa der halben Länge (L) des Lötsteges (Ls) entspricht.

3. Lötvorrichtung nach Anspruch 1 oder 2,
**dadurch gekennzeichnet,**
daß der Querschnitt der Ausdehnungs-Kompensationsstege (AK) derart bemessen ist, daß dort durch die Widerstandserwärmung eine höhere Temperatur entsteht als im Lötsteg (Ls).

4. Lötvorrichtung nach Anspruch 1, 2 oder 3,
**dadurch gekennzeichnet,**
daß die Ausdehnungs-Kompensationsstege (AK) aus einem Material bestehen, dessen thermischer Ausdehnungskoeffizient größer ist als der thermische Ausdehnungskoeffizient des Materials des Lötsteges (Ls).

5. Lötvorrichtung nach einem der vorhergehenden Ansprüche,
**dadurch gekennzeichnet,**
daß jeweils im Bereich eines Haltesteges (Hs) zwischen dem Ausdehnungs-Kompensationssteg (AK) und dem Lötsteg (Ls) eine elektrisch isolierende Abstützung (As) angeordnet ist.

6. Lötvorrichtung nach einem der vorhergehenden Ansprüche,
**dadurch gekennzeichnet,**
daß auf die Unterseite dfes Lötsteges (Ls) der Bügelelektrode (B) eine elektrisch isolierende Keramikbeschichtung (K) aufgebracht ist.

## Claims

1. Soldering device having at least one soldering-iron electrode, which can be heated by electrical resistance heat, especially for soldering electronic components having a large number of poles onto printed-circuit boards, characterized in that the ends of the soldering web (Ls), facing the soldering point, of the soldering-iron electrode (B) are passed back as U-shaped expansion compensation webs (AK), and in that retaining webs (Hs) which are aligned vertically with respect to the soldering web (Ls) and are arranged at a distance (A) from one another are fitted on the inner ends of the expansion compensation webs (AK).

2. Soldering device according to Claim 1, characterized in that the distance (A) between the two retaining webs (Hs) corresponds to approximately half the length (L) of the soldering web (Ls).

3. Soldering device according to Claim 1 or 2, characterized in that the cross-section of the expansion compensation webs (AK) is dimensioned in such a manner that a higher temperature is produced there by the resistance heating than in the soldering web (Ls).

4. Soldering device according to Claim 1, 2 or 3, characterized in that the expansion compensation webs (AK) are composed of a material whose thermal coefficient of expansion is greater than the thermal coefficient of expansion of the material of the soldering web (Ls).

5. Soldering device according to one of the preceding Claims, characterized in that an electrically insulating support (As) is arranged in each case in the region of a retaining web (Hs) between the expansion compensation web (AK) and the soldering web (Ls).

6. Soldering device according to one of the preceding Claims, characterized in that an electrically insulating ceramic coating (K) is applied to the bottom of the soldering web (Ls) of the soldering-iron electrode (B).

## Revendications

1. Dispositif de brasage comportant au moins une électrode en forme d'étrier, qui peut être chauffée par une chaleur produite au moyen d'une résistance électrique, notamment pour la fixation par brasage de composants électroniques comportant un grand nombre de bornes, sur des plaquettes à circuits imprimés,
caractérisé par le fait que les extrémités de la barrette de brasage (Ls), tournée vers le point de brasage, de l'électrode en forme d'étrier (B), sont repliées sous la forme de barrettes de compensation de dilatation (AK) en forme de U, et que des barrettes de retenue (Hs), qui sont perpendiculaires à la barrette de brasage (Ls) et sont situées à une distance réciproque (A), sont disposées sur les extrémités intérieures des barrettes de compensation de dilatation (AK).

2. Dispositif de brasage suivant la revendication 1, caractérisé par le fait que la distance (A) entre les deux barrettes de retenue (Hs) correspond approximativement à la moitié de la longueur (L) de la barrette de brasage (Ls).

3. Dispositif de brasage suivant la revendication 1 ou 2, caractérisé par le fait que la section transversale des barrettes de compensation de dilatation (AK) est dimensionnée de telle sorte qu'en cet endroit il apparaît, sous l'effet de l'échauffement produit par la résistance, une température plus élevée que dans la barrette de brasage (Ls).

4. Dispositif de brasage suivant la revendication 1, 2 ou 3, caractérisé par le fait que les barrettes de compensation de dilatation (AK) sont réalisées en un matériau, dont le coefficient de dilatation thermique est supérieur au coefficient de dilatation thermique du matériau de la barrette de brasage (Ls).

5. Dispositif de brasage suivant l'une des revendications précédentes, caractérisé par le fait qu'un support électriquement isolant (As) est disposé respectivement au niveau d'une barrette de retenue (Hs) entre la barrette de compensation de dilatation (AK) et la barrette de brasage (Ls).

6. Dispositif de brasage suivant l'une des revendications précédentes, caractérisé par le fait qu'un revêtement céramique électriquement isolant (K) est déposé sur la face inférieure de la barrette de brasage (Ls) de l'électrode en forme d'étrier (B).
